# FASCICULE DE BREVET EUROPEEN

(11) **EP 0 666 573 B1**
(45) Date de publication et mention de la délivrance du brevet: **26.06.1996**
(21) Numéro de dépôt: 95400189.7
(22) Date de dépôt: 27.01.1995
(51) Int. Cl.: G11C 16/06, G11C 16/04

(54) **Bascule bistable non volatile programmable par la source, notamment pour circuit de redondance de mémoire**
Source programmierter nichtflüchtiger Flip-Flop für Speicherredundanzschaltung
Non volatile flip-flop, programmed via the source, especially for memory redundancy circuit

(30) Priorité: 31.01.1994 FR 9401035
(43) Date de publication de la demande: 09.08.1995
(73) Titulaire: SGS-THOMSON MICROELECTRONICS S.A., F-94250 Gentilly (FR)
(72) Inventeur: Mirabel, Jean Michel, F-75116 Paris (FR)
(74) Mandataire: Schmit, Christian Norbert Marie

(56) Documents cités:
- EP-A- 0 525 680
- WO-A-93/18518
- IEEE JOURNAL OF SOLID-STATE CIRCUITS., vol.22, no.5, Octobre 1987, NEW YORK US pages 684 - 692 CIAOCA ET AL 'A million-cycle CMOS 256K EEPROM'
- IEEE JOURNAL OF SOLID-STATE CIRCUITS., vol.17, no.5, Octobre 1982, NEW YORK US pages 847 - 851 DONALDSON ET AL 'SNOS 1Kx8 static nonvolatile RAM'

## Description

L'invention concerne les circuits intégrés. Elle a pour objet une bascule bistable non volatile, programmable électriquement. Elle est destinée essentiellement, bien que non exclusivement, à être utilisée dans un circuit de redondance de mémoire en circuit intégré.

Pour bien faire comprendre l'invention dans le contexte où elle a été imaginée, on va d'abord rappeler sommairement les principes des circuits de redondance utilisés actuellement dans les mémoires de grande capacité.

Les circuits de redondance d'une mémoire sont mis en oeuvre lorsque des défauts apparaissent dans les rangées (lignes de mot servant à adresser la mémoire) ou les colonnes (lignes de bit transportant les données à lire ou écrire dans la mémoire).

Par exemple, si une colonne est défectueuse, on la remplace par une colonne de redondance de la manière suivante : l'adresse de la colonne défectueuse est mise en mémoire dans une mémoire d'adresse défectueuse; cette mémoire d'adresse défectueuse est une mémoire de type adressable par son contenu (appelée ci-après mémoire CAM) ; chaque fois qu'une adresse est appliquée à la mémoire principale, cette adresse est également appliquée à la mémoire CAM. Si l'adresse appliquée est identique à l'adresse mémorisée, un circuit de redondance est mis en service et agit pour déconnecter la colonne défectueuse et connecter à sa place une colonne redondante, d'une manière invisible pour l'utilisateur.

En pratique, selon l'organisation de la mémoire principale, si une colonne est défectueuse, on remplacera plutôt un groupe de colonnes contenant cette colonne défectueuse par un groupe de colonnes de redondance : en général, si un groupe de colonnes est défini par un bit d'adresse de la mémoire de grande capacité, c'est ce groupe de colonnes qu'on remplacera dans son ensemble. Dans la suite, pour simplifier, on se contentera de parler du remplacement d'une colonne plutôt que du remplacement d'un groupe de colonnes.

Pour une mémoire principale de plusieurs mégabits, on prévoit la possibilité de réparer plusieurs défauts; il y a donc autant de colonnes de redondance que de colonnes ou de lignes en défaut qu'on veut pouvoir réparer. A chaque colonne de redondance est associée une mémoire CAM respective qui contient l'adresse d'une colonne défectueuse. Si on veut réparer N défauts, il faut N colonnes de redondance et N mémoires CAM. Typiquement N=36 pour une mémoire de 4 ou 16 mégabits.

Si une colonne de la mémoire principale est désignée par une adresse de M bits (par exemple M=5), chaque mémoire CAM contient au moins M+1 bit : M bits pour définir l'adresse d'une colonne défectueuse et un bit de validation pour indiquer que le circuit de redondance correspondant à cette mémoire CAM doit effectivement être activé lorsque l'adresse défectueuse est appliquée à la mémoire CAM.

Pour réaliser les mémoires CAM, on a d'abord utilisé des groupes de fusibles physiques, grillés électriquement ou grillés par un faisceau laser, chaque fusible représentant un bit d'adresse ou un bit de validation. Ces fusibles présentaient des inconvénients (fiabilité, encombrement, consommation, difficulté de programmation) et ont été rapidement remplacés par des cellules de mémoire non volatile non effaçables. Ces dernières présentaient également des inconvénients (consommation de courant importante), et on s'est orienté progressivement vers l'utilisation de bascules bistables programmables comprenant deux transistors à grille flottante pour chaque bit d'adresse ou de validation. Un tel arrangement est connu du document EP-A- 0 525 680. La préambule de la revendication 1 se fonde à ce document.

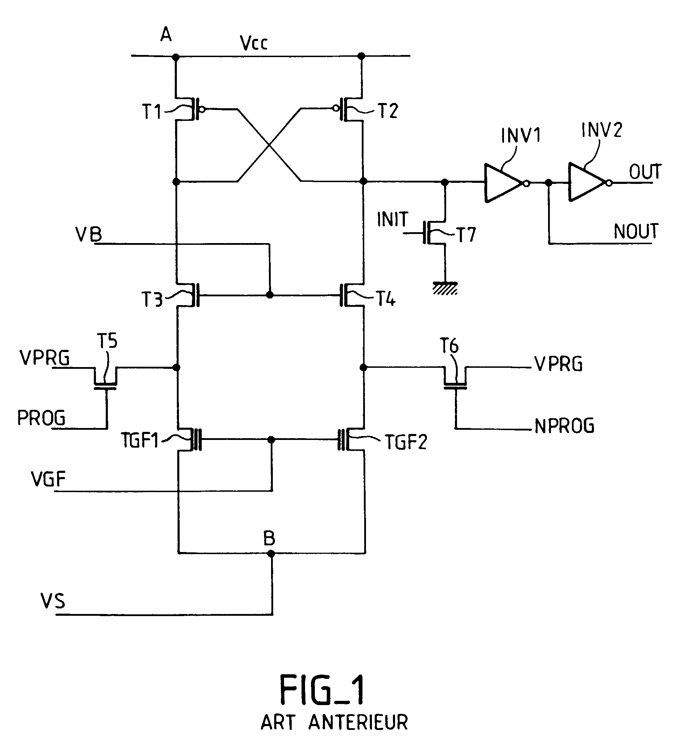

La figure 1 représente une bascule bistable programmable non volatile de la technique antérieure, constituant une cellule de mémorisation d'un bit d'adresse défectueuse (ou d'un bit de validation), et constituant donc une des M+1 cellules d'une mémoire CAM d'adresse défectueuse.

La sortie OUT de cette cellule est à un niveau logique 0 ou à 1 selon l'état dans lequel la bascule est programmée. Cette sortie définit donc la valeur d'un bit d'adresse (ou la valeur du bit de validation).

Si la cellule correspond à un des M bits d'adresse défectueuse, la sortie de chaque cellule de ces M bits d'adresse est appliquée à une entrée de porte OU-Exclusif (non représentée). La porte OU-Exclusif reçoit sur une autre entrée un bit d'adresse correspondant, reçu par la mémoire principale; les sorties des portes OU-Exclusif correspondant aux différents bits d'adresse d'une même mémoire d'adresse défectueuse sont appliquées à une entrée d'une porte NOR (non représentée) ; la sortie de cette dernière fournit un niveau logique 1 uniquement s'il y a coïncidence entre tous les bits d'adresse appliqués et tous les bits correspondants de la mémoire d'adresse défectueuse. La sortie de la porte NOR est validée par la sortie de la cellule de mémoire correspondant au bit de validation, par exemple grâce à une porte ET (non représentée). La sortie de la porte ET est la sortie de la mémoire CAM et sert à mettre en service un chemin de redondance chaque fois que l'adresse appliquée à la mémoire principale correspond à l'adresse défectueuse enregistrée.

Dans le cas général, il y a N mémoires d'adresse défectueuse, par exemple N=36. Lors du test de la mémoire principale, la détection d'une colonne défectueuse déclenche le stockage de l'adresse de cette colonne dans une des mémoires CAM. Les différentes mémoires CAM sont ainsi successivement programmées au fur et à mesure de la détection des défauts. En fonctionnement normal de la mémoire principale, les adresses de celle-ci sont appliquées simultanément à toutes les mémoires CAM. S'il y a correspondance de l'adresse appliquée et de l'adresse stockée dans l'une d'elles, le chemin de redondance correspondant à celle-ci est activé.

Pour permettre la programmation d'une adresse défectueuse dans une mémoire CAM, on prévoit donc qu'un bit d'adresse respectif de la mémoire principale est appliqué à chaque cellule de la mémoire CAM. La programmation est effectuée sur ordre de l'appareil de test en cas de détection d'un défaut à l'adresse en cours de test.

La cellule de mémoire individuelle représentée à la figure 1 comporte deux branches avec un transistor à grille flottante TGF1, TGF2 dans chaque branche; les branches sont agencées de manière à former une bascule bistable dès qu'un de ces deux transistors est programmé; l'état de la bascule, représenté par la sortie OUT et correspondant à un bit d'adresse ou un bit de validation, est alors fonction de celui des deux transistors qui est programmé. Au départ les deux transistors sont dans un état non-programmé, ou état vierge. Lors du test de la mémoire, on programme l'un des deux transistors pour obtenir soit un 0 soit un 1 en sortie OUT de la cellule, définissant ainsi un état stable définitif 0 ou 1 de la cellule.

Plus précisément, la cellule de la figure 1 comprend deux branches identiques en parallèle entre une borne d'alimentation A (potentiel Vcc de l'ordre de 3 volts) et une borne B; la borne B est à un potentiel VS nul en mode de lecture ou de programmation et peut aussi être portée à un potentiel VS élevé (12 volts) en mode d'effacement si un mode d'effacement est prévu (flash EPROM); en série dans chaque branche, on trouve un transistor à canal P (T1, T2), un transistor à canal N (T3, T4), et un transistor à grille flottante (TGF1, TGF2). La grille du transistor à canal P (T1, T2) de l'une des branches est reliée au drain du transistor à canal P (T2, T1) de l'autre branche. Les grilles des transistors à canal N (T3, T4) sont reliées ensemble à un potentiel commun VB dont la valeur dépend du mode de fonctionnement (environ 1,8 volt en lecture; zéro volt en programmation ou effacement pour avoir 1 volt sur le drain des cellules en lecture). Les transistors T3 et T4 sont des transistors d'isolation pour empêcher la transmission aux transistors T1 et T2 des tensions relativement élevées appliquées aux transistors à grille flottante en mode de programmation ou effacement. Les grilles des transistors à grille flottante TGF1, TGF2, sont reliées à un potentiel commun VGF dépendant du fonctionnement (3 volts environ en lecture, 12 volts environ en programmation). La source de ces transistors est reliée au noeud B (potentiel VS). Les potentiels de drain des transistors à grille flottante sont contrôlés par des transistors T5 et T6 respectivement, permettant soit de relier le drain à un potentiel de programmation VPRG (transistor T5 ou T6 conducteur) soit de laisser le drain en haute impédance (transistor T5 ou T6 bloqué). En mode de programmation, la grille du transistor T5 est contrôlée par un signal de programmation PROG et la grille de T6 par un signal complémentaire NPROG. De la sorte on choisit selon l'état du signal PROG celui des deux transistors à grille flottante qui doit être programmé et celui qui doit rester vierge. En mode de lecture, le drain des transistors T5 et T6 reste en haute impédance, la tension VPRG n'étant pas appliquée à ces drains.

La cellule est appelée "bistable" car elle possède un état stable parmi deux possibles, l'état stable qu'elle prend dépendant de celui des deux transistors qui a été programmé. L'état de la cellule est lu sur le drain d'un des transistors à canal P (T2 par exemple). Ce drain est relié à l'entrée d'un premier inverseur INV1 suivi d'un deuxième inverseur INV2. La sortie de INV2 est la sortie OUT de la cellule. La sortie de INV1 sert de sortie complémentaire NOUT si on en a besoin.

Enfin, un transistor supplémentaire T7 peut permettre uniquement en mode de test, pour éviter les noeuds flottants quand T3 et T4 sont bloqués, de mettre à la masse temporairement (pour une initialisation de l'état de la cellule à chaque remise sous tension) l'entrée de l'inverseur INV1; la grille de ce transistor est commandée par un créneau d'initialisation INIT produit par un circuit classique de remise sous tension ("Power On Reset") non représenté.

Pour programmer la bascule dans un état ou dans un autre, on applique une tension de programmation élevée (VGF = 12 volts environ) sur les grilles de commande des transistors à grille flottante, et on applique une tension moyenne (VPRG = 5 à 7 volts) sur le drain de celui des transistors TGF1 ou TGF2 qu'on veut programmer. Le signal PROG/NPROG définit l'état 0 ou 1 qu'on veut programmer. La programmation s'effectue par électrons chauds, c'est-à-dire avec circulation de courant dans le transistor qu'on programme. Les transistors T3 et T4 sont bloqués (VB=0) pendant la programmation, afin que la tension VPRG ne soit pas appliquée aux transistors T1 et T2 qui sont des transistors basse tension. Le potentiel de source VS est mis à zéro.

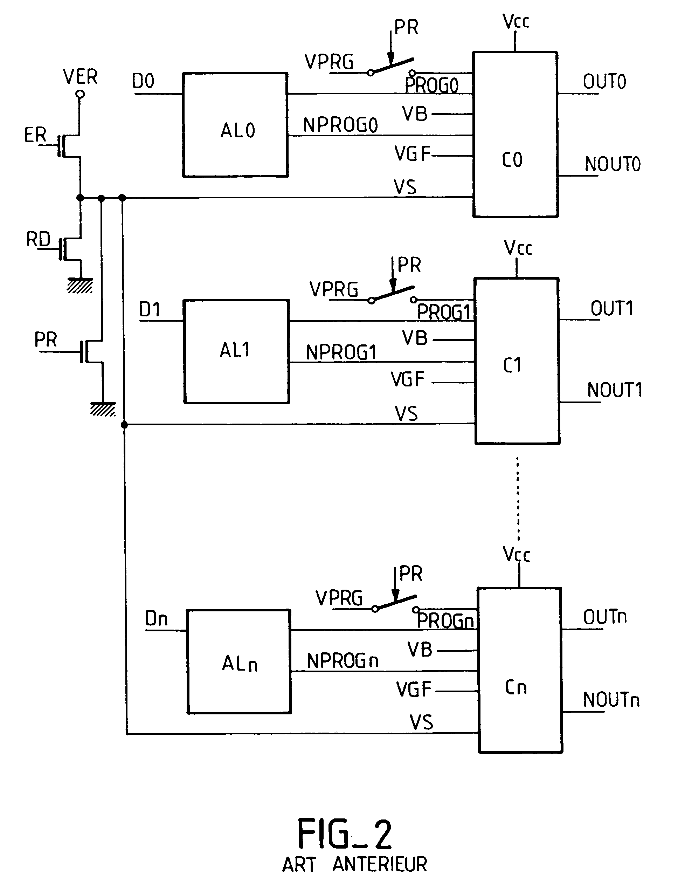

La structure générale d'un groupe de cellules bistables constituant une mémoire adressable est représentée à la figure 2, dans le cas où on désire en outre pouvoir effacer globalement les cellules par application d'un potentiel élevé sur les sources des transistors (cas où les transistors à grille flottante sont de type flash EPROM).

Les cellules bistables sont désignées par C0 à Cn. Chacune peut recevoir la tension VPRG, la tension VGF, la tension Vcc, la tension VB, la tension VS (toutes ces tensions communes à toutes les cellules) et les données de programmation spécifiques à chaque cellule selon l'état dans laquelle on veut la programmer PROG0, NPROG0 pour la cellule C0; PROG1, NPROG1 pour la cellule C1, etc.

Les cellules fournissent, en mode de lecture, les sorties complémentaires OUT0, NOUT0 pour la cellule C0, et les signaux similaires pour les autres cellules OUT1, NOUT1, etc.

En mode de lecture ou de programmation, VS est mis à zéro par un signal de commande RD (lecture) ou PR (programmation). En mode d'effacement, VS est mis à une haute tension VER (environ 12 volts) par un signal de commande ER. En mode de programmation (PR) la tension VPRG est effectivement appliquée aux transistors T5 et T6 des cellules.

En mode de programmation, les signaux de données de programmation (PROG0, NPROG0 par exemple) doivent être fournis à un niveau de potentiel suffisant pour commander les transistors T5 et T6 (figure 1) et transmettre la tension VPRG qui est élevée (5 à 7 volts). Or les signaux de données de programmation sont simplement des bits d'adresse D0 à Dn venant du décodeur d'adresses de la mémoire principale; ils viennent donc de circuits logiques à basse tension (Vcc = 3 volts en général pour ce type de circuit). Il est donc nécessaire de placer un élévateur de tension entre chaque signal de donnée (D0 à Dn) à basse tension et les entrées PROG0, NPROG0 ... PROGn, NPROGn à plus haute tension. Ces élévateurs de tension, désignés par AL0 à ALn sur la figure 2, sont encombrants (une dizaine de transistors chacun par exemple).

Un but de l'invention est de réduire l'encombrement global de la mémoire composée d'un groupe de cellules bistables programmables non volatiles.

Pour améliorer les mémoires de ce type, l'invention propose de programmer les transistors à grille flottante par la source, c'est-à-dire en appliquant une tension de programmation élevée sur la source et non sur le drain, et en mettant le drain à la masse ou en haute impédance selon qu'on doit ou non programmer le transistor.

Plus précisément, l'invention concerne une mémoire composée de cellules bistables comportant deux transistors à grille flottante chacune, caractérisée en ce que la mémoire comporte des moyens pour appliquer, en mode de programmation, une première tension de programmation fixe sur les sources des transistors à grille flottante des différentes cellules, une deuxième tension de programmation fixe sur les grilles de commande, et une tension nulle ou un état haute impédance sur les drains selon l'état de programmation désiré pour la cellule. La référence de tension nulle est la tension appliquée aux sources en mode de lecture.

L'invention utilise de préférence des mémoires à transistors de type flash EPROM, programmables par électrons chauds et effaçables par application d'un champ suffisant entre grille et source.

La structure de la cellule de mémoire n'est donc pas modifiée, mais la commande de programmation est très différente et les circuits de programmation sont donc modifiés en conséquence, incluant en particulier la suppression des circuits élévateurs de tension AL0 à ALn.

D'autres caractéristiques et avantages de l'invention apparaîtront à la lecture de la description détaillée qui suit et qui est faite en référence aux dessins annexés dans lesquels :
- la figure 1, déjà décrite représente une cellule de mémorisation connue;
- la figure 2 représente une organisation de mémoire à plusieurs cellules de l'art antérieur;
- la figure 3 représente une organisation de mémoire selon l'invention.

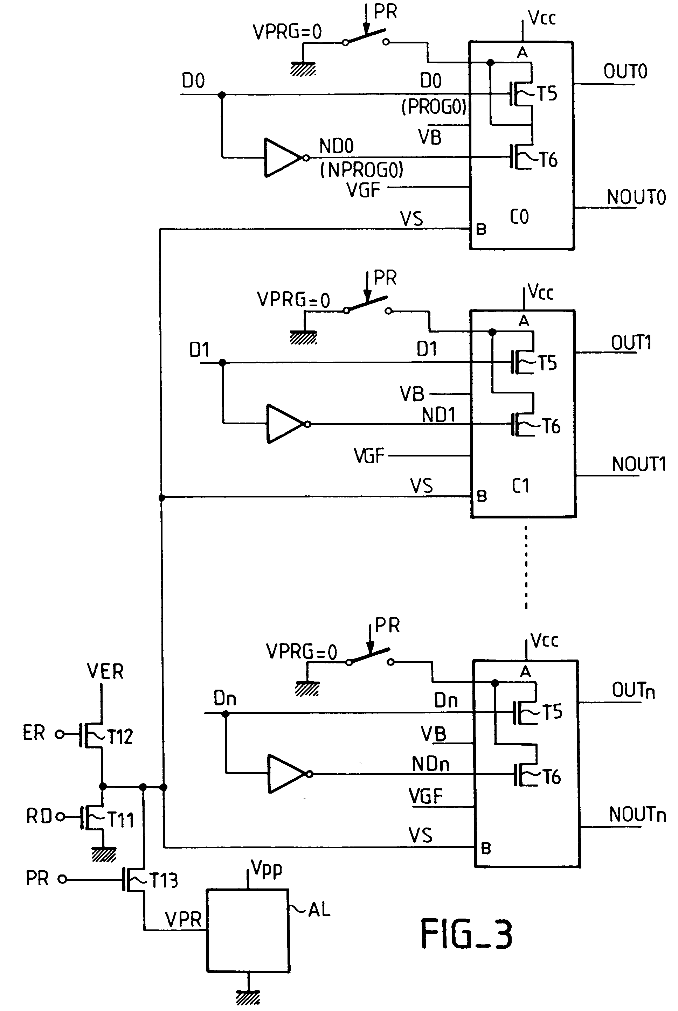

Sur la figure 3, on voit l'organisation générale de la mémoire selon l'invention, qu'on supposera être une mémoire d'adresse défectueuse faisant partie des circuits de redondance d'une mémoire principale et destinée à stocker des adresses d'éléments défectueux de la mémoire principale.

Les cellules de mémoire sont constituées comme à la figure 1 et peuvent donc recevoir les tensions suivantes :
- Vcc (environ 3 volts) sur le noeud A
- VPRG égal selon l'invention à 0 volt, sur le drain des transistors T5 et T6, en mode de programmation seulement;
- VGF sur les grilles des transistors à grille flottante, égal à environ 12 volts en mode de programmation, ou 3 volts en mode de lecture;
- VS sur le noeud B, égal à environ 5 à 7 volts en mode de programmation, 0 volt en mode de lecture, et environ 12 volts en mode d'effacement;
- VB, potentiel de polarisation des grilles des transistors T3 et T4, dont la valeur est suffisante (environ 1,8 volts) pour rendre ces transistors conducteurs en mode de lecture et pour les bloquer (VB=0) en mode de programmation;
- une donnée de programmation, sous forme d'un signal logique et de son complément, D0 et ND0 pour la cellule 0 par exemple, D1, ND1 à Dn, NDn pour les autres; ces signaux logiques, de bas niveau de tension, viennent du décodeur d'adresse de la mémoire principale et sont directement appliqués aux grilles des transistors T5 et T6 sans l'intermédiaire d'élévateurs de tension.

On a représenté sur la figure 3 les éléments de circuit très simples permettant d'appliquer différents potentiels VS possibles au noeud B des cellules.

Un premier transistor T11 est rendu conducteur par un signal RD de commande de mode de lecture. Il permet de transmettre alors le potentiel de masse (VS=0) sur le noeud B de toutes les cellules à la fois. Un deuxième transistor T12 est rendu conducteur par un signal ER de commande de mode d'effacement. Il permet de transmettre un potentiel élevé d'effacement VS=VER (par exemple 12 volts) sur le noeud B de toutes les cellules à la fois. Enfin, un troisième transistor T13 est rendu conducteur par un signal PR de commande de programmation. Il permet de transmettre un potentiel de programmation intermédiaire VS=VPR (5 à 7 volts) sur le noeud B de toutes les cellules à la fois. Ce potentiel VPR est fourni par un circuit d'alimentation AL, par exemple à partir d'une tension d'alimentation Vpp externe de 12 volts.

Pour la programmation, la donnée de programmation D0,ND0 définit lequel des transistors T5, T6 de la cellule C0 est rendu conducteur, l'autre étant alors bloqué. Celui qui est rendu conducteur met le drain du transistor à grille flottante correspondant à la masse; la source est à 5 à 7 volts et la grille est à une tension de programmation d'une douzaine de volts le transistor à grille flottante est programmé par électrons chauds. L'autre reçoit les mêmes tensions de grille et de source mais son drain reste en haute impédance : il n'est pas programmé.

La lecture et l'effacement se font selon des procédures classiques : pour la lecture, les drains des transistors T5 et T6 ne reçoivent plus la tension de programmation VPRG et restent en haute impédance, le noeud B à la masse; pour l'effacement, le noeud B est à 12 volts, les grilles des transistors à grille flottante à la masse.

Grâce à l'invention, on peut se contenter d'un seul circuit élévateur de tension AL pour l'ensemble des cellules au lieu d'un élévateur pour chaque cellule. On gagne ainsi de la place sur le circuit intégré.

L'invention est applicable à des cellules de mémoire différentes de celles représentées à la figure 1. Elle est applicable notamment aux cellules décrites dans les demandes de brevet déposées simultanément par la Demanderesse et dans lesquelles par exemple la cellule comporte un transistor supplémentaire commandé par la sortie OUT et intercalé entre le transistor T2 et le transistor T4 (pour déséquilibrer la cellule afin qu'elle ait un état stable bien déterminé même avant programmation); ou encore une cellule dans laquelle des transistors d'isolation sont intercalés entre les transistors T5 et T6 et les drains de TGF1 et TGF2, ces transistors d'isolation, commandés par un même signal, permettant de sélectionner un seul groupe de cellules à la fois et étant bloqués en mode de lecture pour éviter la transmission parasite de signaux vers la cellule.

## Revendications

1. Mémoire non volatile programmable électriquement, composée de cellules bistables à deux transistors à grille flottante (TGF1, TGF2), caractérisée en ce que la mémoire comporte des moyens (T13, AL) pour appliquer, en mode de programmation, une première tension de programmation fixe (VPR) sur les sources des transistors à grille flottante des différentes cellules, une deuxième tension de programmation fixe (VGF) sur les grilles de commande, et une tension nulle ou un état haute impédance sur les drains selon l'état de programmation désiré pour la cellule, la référence de tension nulle étant la tension appliquée aux sources en mode de lecture.

2. Mémoire selon la revendication 1, caractérisée en ce que les transistors à grille flottante sont de type flash EPROM, programmables par électrons chauds et effaçables par application d'un champ suffisant entre grille et source.

3. Mémoire selon l'une des revendications 1 et 2, caractérisée en ce que chaque cellule comporte deux branches avec dans chaque branche en série au moins un premier transistor (T1, T2) et un deuxième transistor à grille flottante (TGF1, TGF2), la grille du premier transistor étant reliée au drain du deuxième et réciproquement pour réaliser une bascule bistable lorsque la bascule est programmée.

4. Mémoire selon l'une des revendications précédentes, caractérisée en ce qu'elle fait partie d'un circuit de redondance d'une mémoire principale pour stocker de manière non-volatile les adresses d'éléments défectueux de la mémoire principale.

## Patentansprüche

1. Elektrisch programmierbarer, nichtflüchtiger Speicher, bestehend aus Flip-Flop-Zellen mit zwei Transistoren mit Floating Gate (TGF1, TGF2),
dadurch gekennzeichnet, daß der Speicher Mittel (T13, AL) aufweist, um im Programmiermodus eine erste fixe Programmierspannung (VPR) an die Sourcen der Transistoren mit Floating Gate der verschiedenen Zellen anzulegen, eine zweite fixe Programmierspannung (VGF) an die Steuergitter anzulegen, und gemäß dem für die Zelle gewünschten Programmierzustand eine Nullspannung oder einen Zustand hoher Impedanz an die Drains anzulegen, wobei die Nullspannungsreferenz die im Lesemodus an die Sourcen angelegte Spannung ist.

2. Speicher nach Anspruch 1,
dadurch gekennzeichnet, daß die Transistoren mit Floating Gate Flash-EPROM-Transistoren sind, die durch heiße Elektronen programmierbar und durch Anlegen eines ausreichenden Feldes zwischen Gate und Source löschbar sind.

3. Speicher nach einem der Ansprüche 1 und 2,
dadurch gekennzeichnet, daß jede Zelle zwei Zweige mit mindestens einem ersten Transistor (T1, T2) und einem zweiten Transistor mit Floating Gate (TGF1, TGF2), die in jedem Zweig in Reihe geschaltet sind, aufweist, wobei das Gate des ersten Transistors mit dem Drain des zweiten Transistors verbunden ist und umgekehrt, um eine bistabile Kippschaltung herzustellen, wenn die Schaltung programmiert wird.

4. Speicher nach einem der vorherigen Ansprüche,
dadurch gekennzeichnet, daß er Teil einer Redundanzschaltung eines Hauptspeichers zur nichtflüchtigen Speicherung der Adressen von defekten Elementen des Hauptspeichers ist.

## Claims

1. Electrically programmable non-volatile memory, composed of bistable cells with two floating gate transistors (TGF1, TGF2), characterised in that the memory includes means (T13, AL) for applying, in programming mode, a first fixed programming voltage (VPR) to the sources of the floating gate transistors of the different cells, a second fixed programming voltage (VGF) to the control gates, and a zero voltage or a high-impedance state to the drains according to the programming state required for the cell, the zero voltage reference being the voltage applied to the sources in read mode.

2. Memory according to Claim 1, characterised in that the floating gate transistors are of the flash EPROM type, programmable by hot electrons and erasable by the application of a sufficient field between gate and source.

3. Memory according to one of Claims 1 and 2, characterised in that each cell has two arms with, in each arm in series, at least a first transistor (T1, T2) and a second floating gate transistor (TGF1, TGF2), the gate of the first transistor being connected to the drain of the second and vice versa in order to produce a bistable flip-flop when the flip-flop is programmed.

4. Memory according to one of the preceding claims, characterised in that it forms part of a redundancy circuit of a main memory for storing, in a non-volatile fashion, the addresses of defective elements of the main memory.
